# FASCICULE DE BREVET EUROPEEN

(11) **EP 4 587 805 B1**
(45) Date de publication et mention de la délivrance du brevet: **25.03.2026**
(21) Numéro de dépôt: 23793413.8
(22) Date de dépôt: 12.09.2023
(51) Int. Cl.: G01M 15/00, H02P 21/20, B64F 5/60, G01R 31/34

(54) **PROCÉDÉ DE CALIBRATION D'UN MODÈLE D'ESTIMATION D'UN COUPLE FOURNI PAR UNE MACHINE ÉLECTRIQUE**
VERFAHREN ZUR KALIBRIERUNG EINES MODELLS ZUR SCHÄTZUNG EINES VON EINER ELEKTRISCHEN MASCHINE GELIEFERTEN DREHMOMENTS
METHOD FOR CALIBRATING A MODEL FOR ESTIMATING A TORQUE SUPPLIED BY AN ELECTRIC MACHINE

(30) Priorité: 16.09.2022 FR 2209360
(43) Date de publication de la demande: 23.07.2025
(73) Titulaire: Safran Helicopter Engines, 64510 Bordes (FR)
(72) Inventeur: LEMAY, David Bernard Martin, 77550 Moissy-Cramayel (FR); FREALLE, Jean-Luc Charles Gilbert, 77550 Moissy-Cramayel (FR); KLONOWSKI, Thomas, 77550 Moissy-Cramayel (FR)
(74) Mandataire: Regimbeau
(86) Numéro de dépôt international: PCT/FR2023/051386
(87) Numéro de publication internationale: WO 2024/056971

(56) Documents cités:
- CN-A- 111 812 506
- CN-B- 106 452 266
- US-A1- 2003 218 439

## Description

### DOMAINE TECHNIQUE

La présente demande concerne un procédé de calibration d'un modèle d'estimation d'un couple fourni par une machine électrique. La demande concerne également un dispositif de calibration pour l'estimation d'un couple fourni par une machine électrique.

### ARRIERE-PLAN TECHNOLOGIQUE

Une machine, thermique ou électrique, peut être un moteur ou un générateur, et est classiquement utilisée dans l'industrie pour fournir de la puissance à un système. En particulier, des machines électriques sont utilisées à l'heure actuelle pour fournir de la puissance propulsive vers un propulseur d'aéronef tel qu'un rotor d'hélicoptère, une hélice, ou une soufflante de turboréacteur. La machine fournit de la puissance mécanique sous forme de couple et de vitesse sur un arbre en rotation. La machine est contrôlée par un système électronique de contrôle dans le but de suivre une consigne de vitesse ou de couple répondant aux besoins du système.

La maîtrise du couple fourni par la machine en fonctionnement est importante pour le bon fonctionnement du système. En particulier, lorsqu'une machine électrique est utilisée pour de la propulsion aéronautique, la maîtrise du couple est un enjeu de sécurité du vol. En effet, l'application d'un couple erroné peut avoir des conséquences critiques pour la sécurité du vol. L'application d'un couple trop important peut conduire à dépasser le couple maximum pour lequel la chaine de transmission mécanique a été conçue et ainsi générer un endommagement qui peut conduire à la rupture d'une pièce critique comme une boîte de transmission principale d'hélicoptère ou une hélice. L'application d'un couple trop peu important, c'est-à-dire d'un couple inférieur au couple maximum que devrait pouvoir fournir le système propulsif, peut amener à un manque de puissance propulsive qui peut être critique dans certaines phases de vol.

Une incertitude sur l'information de couple fournie par la machine est prise en compte dans la conception de la machine et de son système de contrôle, afin de garantir la sécurité du vol. Néanmoins, une incertitude importante induit soit un surdimensionnement de la transmission mécanique et donc un alourdissement de la masse à vide de l'aéronef, soit une réduction des performances de l'aéronef (charge transportable, distance franchissable, etc.), qui dégrade sa viabilité économique.

L'information de couple fourni par une machine thermique ou électrique peut être obtenue par mesure directe à l'aide d'un capteur de couple, encore appelé couplemètre disposé par exemple sur l'arbre moteur de la machine thermique ou en un autre endroit de la chaine de transmission mécanique. Un tel capteur mesure en général la déformation d'une pièce mécanique soumise au couple fourni par la machine. La mesure obtenue est précise. En contrepartie, elle nécessite une électronique dédiée, avec les problématiques de gestion de pannes et fiabilité associées ; une procédure de calibration du capteur est généralement nécessaire pour obtenir la précision voulue ; enfin, un capteur de couple est un dispositif lourd, encombrant et cher, et cela a donc un impact négatif sur la conception du système. Dans le cas de machines électriques, le système électronique de contrôle de ces machines se base sur une mesure de courant électrique parcourant la machine, par un capteur de courant. Il est alors possible d'estimer le couple fourni par la machine électrique par la relation suivante : T = Kt * I, où T est le couple, I est le courant électrique dans la machine, et Kt est une constante de couple caractéristique de la machine considérée. Cette méthode d'estimation, par mesure indirecte du couple, est simple et peu coûteuse en termes d'intégration (coût, masse, fiabilité) puisqu'elle se base sur un capteur de courant prévu par conception. Mais une telle estimation du couple manque de précision Pour une machine électrique prévue dans un système de propulsion aéronautique, ce manque de précision sur la valeur de couple estimée pose un problème pour la sécurité des vols vol.

Les facteurs d'imprécision de la mesure indirecte du couple fourni par la machine électrique par le biais d'une mesure de courant électrique sont principalement :
- la mesure du courant électrique elle-même, qui a généralement une précision de l'ordre de +/-5 à 10% de la pleine échelle de mesure,
- la constante de couple Kt de la machine électrique, qui est une caractéristique associée à une topologie de machine donnée, mais qui peut varier en fonction des tolérances de fabrication et d'assemblage, l'ordre de grandeur de la dispersion sur la valeur Kt étant également de +/- 5 à 10% de la valeur nominale « moyenne », et
- diverses autres sources d'imprécision, notamment celles liées à l'électronique de contrôle de la machine électrique, aux conditions d'utilisation opérationnelles et notamment la température, la tension électrique d'alimentation, ou encore le vieillissement, etc.

Dans l'état de l'art, le document CN 106 452 266 B divulgue un procédé de calibration d'un moteur électrique qui consiste à déterminer le modèle d'estimation du couple fourni par le moteur de manière automatique, ce modèle établissant une relation entre le courant d'entrée et le couple de sortie correspondant. Le document CN 111 812 506 A divulgue également un procédé de calibration d'un moteur électrique qui consiste à déterminer le modèle d'estimation du couple fourni par le moteur de manière automatique, dans lequel les points de calibration du modèle sont obtenus de manière itérative. Le document US 2003/218439 A1 divulgue un procédé de diagnostic d'un moteur électrique comprenant une régulateur de courant et une unité de contrôle, cette dernière comprenant notamment une table contenant la relation entre la consigne de couple et le courant requis pour obtenir le couple correspondant à la consigne ainsi qu'un modèle contenant la relation entre la consigne de couple et la tension estimée à la sortie du régulateur de courant.

### EXPOSE GENERAL

Un but de la présente demande est de proposer un procédé de calibration d'un modèle d'estimation d'un couple fourni par une machine électrique et un dispositif de calibration correspondant, permettant d'améliorer la précision d'une estimation de couple basé sur une mesure de courant électrique dans la machine électrique, qui permet de s'affranchir de la nécessité d'intégrer un capteur de mesure spécifique de couple avec des problématiques d'intégration (coût, masse, poids) et de fiabilité, et qui est simple de mise en œuvre.

Selon un premier aspect, la présente demande concerne un procédé de calibration d'un modèle d'estimation d'un couple fourni par une machine électrique, notamment par un moteur à aimants permanents, comprenant les étapes suivantes :
E1 mesure d'un courant électrique dans la machine électrique pour un point de fonctionnement de la machine électrique ;
E2 estimation du couple fourni par la machine électrique pour ledit point de fonctionnement de la machine électrique, à partir du courant électrique mesuré et du modèle d'estimation associant un couple de sortie à un courant électrique d'entrée ;
E3 mesure d'un couple de référence fourni par la machine électrique pour ledit point de fonctionnement de la machine électrique ;
E4 comparaison du couple estimé avec le couple de référence ; et
E5 en fonction de ladite comparaison, ajustement du modèle d'estimation de sorte à réduire, voire annuler, une différence entre le couple estimé et le couple de référence.

Certaines caractéristiques préférées mais non limitatives du procédé de calibration selon le premier aspect sont les suivantes, prises individuellement ou en combinaison :
- le procédé comprend en outre une étape E6 d'enregistrement du modèle d'estimation ajusté dans une mémoire d'un système de contrôle ;
- les étapes E1 à E4 sont répétées pour plusieurs points de fonctionnement différents de la machine électrique ;
- le modèle d'estimation comprend une fonction affine, et dans lequel l'ajustement du modèle d'estimation comprend un ajustement d'une pente et/ou d'une ordonnée à l'origine de la fonction affine ;
- le modèle d'estimation comprend une table de correspondance associant à chacun d'une pluralité de courants électriques d'entrée un couple de sortie correspondant, et dans lequel l'estimation du couple à l'étape E2 comprend un recalage d'au moins une valeur de couple de sortie de la table de correspondance lors de l'étape E5 en fonction de la comparaison entre le couple estimé et le couple de référence effectuée à l'étape E4, de sorte à réduire voire annuler la différence entre le couple estimé et le couple de référence ;
- le modèle d'estimation comprend un ensemble de tables de correspondance, chaque table de correspondance étant associée à une température parmi un ensemble de températures de fonctionnement de la machine électrique, et dans lequel l'estimation du couple à l'étape E2 comprend une sous-étape de sélection d'une table de correspondance associée à une température de la machine électrique au point de fonctionnement ;
- le modèle d'estimation est ajusté de sorte à réduire, voire annuler, une différence entre le couple estimé et le couple de référence, sur une plage de courant électrique prédéterminée [Ik, In], et/ou pour une plage de température de fonctionnement prédéterminée ; et/ou
- le procédé comprend : une étape de calibration de la machine électrique, comprenant une sous-étape de mesure de la force électromotrice à vide de la machine électrique et une sous-étape de mesure d'une vitesse de rotation de la machine électrique, pour un point de fonctionnement de la machine électrique, et une sous-étape de détermination d'un modèle de machine électrique associant à la force électromotrice une vitesse de rotation de la machine électrique, à partir de la force électromotrice et de la vitesse de rotation mesurées ; une étape de calibration du système de contrôle, comprenant une sous-étape de mesure d'un courant électrique dans le système de contrôle sur un banc de charge statique équipé d'un capteur de courant étalon pour obtenir une mesure de courant de référence, une sous-étape de calcul d'une erreur de mesure du courant quadratique du système de contrôle par rapport à la mesure du courant de référence, et une sous-étape de création d'un modèle de conformation afin de corriger la mesure de courant commandé par le système de contrôle à partir de la mesure du courant de référence; et une étape d'enregistrement dans l'unité de contrôle du modèle de machine électrique et du modèle de conformation du système de contrôle.

Selon un deuxième aspect, la présente demande propose un dispositif de calibration pour l'estimation d'un couple fourni par une machine électrique, notamment par un moteur à aimants permanents, comprenant :
- un dispositif de mesure d'un courant électrique adapté pour mesurer le courant électrique dans la machine électrique pour un point de fonctionnement de la machine électrique ;
- un modèle d'estimation associant un couple de sortie à un courant électrique d'entrée, de sorte que le modèle d'estimation est adapté pour estimer un couple fourni par la machine électrique pour ledit point de fonctionnement de la machine électrique, à partir du courant électrique mesuré ;
- un couplemètre adapté pour mesurer un couple de référence fourni par la machine électrique pour ledit point de fonctionnement de la machine électrique ; et
- une unité de contrôle adaptée pour comparer le couple estimé avec le couple de référence, l'unité de contrôle étant en outre adaptée pour ajuster le modèle d'estimation en fonction de ladite comparaison, de sorte à réduire, voire annuler, une différence entre le couple estimé et le couple de référence.

Optionnellement, le dispositif de calibration selon le deuxième aspect comprend en outre :
- une première enceinte adaptée pour reproduire des premières conditions extérieures, la première enceinte étant adaptée pour recevoir la machine électrique lors de la calibration ; et
- une deuxième enceinte adaptée reproduire des deuxièmes conditions extérieures, la deuxième enceinte étant adaptée pour recevoir le système de contrôle de la machine électrique lors de la calibration.

### DESCRIPTION DES FIGURES

D'autres caractéristiques, buts et avantages de la présente demande apparaîtront à la lecture de la description détaillée qui va suivre, donnée à titre d'exemple non limitatif, qui sera illustrée par les figures suivantes :
La figure 1 est un schéma illustrant un dispositif de calibration pour l'estimation d'un couple fourni par une machine électrique selon un mode de réalisation.
Les figures 2a et 2b sont des graphes illustrant une calibration d'un modèle d'estimation du couple fourni par une machine électrique obtenue dans un procédé de calibration selon un mode de réalisation.
La figure 3 est un schéma illustrant un procédé de calibration pour l'estimation d'un couple fourni par une machine électrique selon un mode de réalisation.
La figure 4 est un schéma illustrant une étape d'estimation d'un couple fourni par une machine électrique dans le cadre d'un procédé de calibration selon un mode de réalisation.
La figure 5 est un schéma illustrant une étape de calibration d'une machine électrique, une étape de calibration d'un système de contrôle, et une étape d'enregistrement d'un modèle d'estimation dans une unité de contrôle, dans le cadre d'un procédé de calibration selon un mode de réalisation.

### DESCRIPTION DETAILLEE

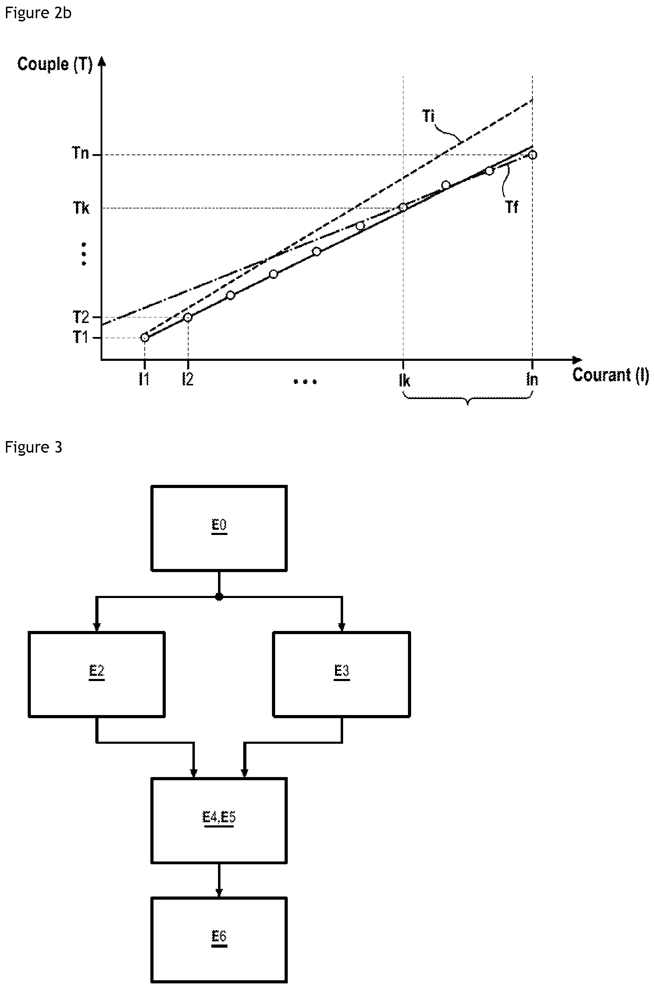

Un procédé de calibration, également appelé procédé de conformation, d'un modèle d'estimation d'un couple fourni par une machine électrique 10, notamment par un moteur à aimants permanents, est illustré à titre d'exemple non limitatif en figure 3. Le procédé de calibration comprend les étapes suivantes :
E1 : mesure d'un courant électrique dans la machine électrique 10 pour un point de fonctionnement de la machine électrique 10 ;
E2 : estimation du couple fourni par la machine électrique 10 pour ledit point de fonctionnement de la machine électrique 10, à partir du courant électrique mesuré et d'un modèle d'estimation associant un couple de sortie à un courant électrique d'entrée ;
E3 : mesure d'un couple de référence fourni par la machine électrique 10 pour ledit point de fonctionnement de la machine électrique 10 ;
E4 : comparaison du couple estimé avec le couple de référence ; et
E5 : en fonction de ladite comparaison, ajustement du modèle d'estimation de sorte à réduire, voire annuler, une différence entre le couple estimé et le couple de référence.

Le modèle d'estimation peut par exemple être destiné à être utilisé en vol lors du fonctionnement d'une machine électrique 10 destinée à fournir un couple à un système propulsif d'un aéronef.

L'estimation du couple est ainsi réalisée par mesure indirecte, à partir de la mesure de courant électrique dans la machine électrique 10. Par conséquent, on bénéficie d'une estimation du couple précise, qui permet d'éviter le recours à un capteur spécifique de mesure de couple, et qui utilise un capteur 30 de mesure du courant électrique dans la machine électrique 10 naturellement présent.

La calibration du modèle d'estimation du couple est ainsi réalisée sur une chaîne complète comprenant notamment un dispositif de mesure du courant électrique 30, un système de contrôle 20 de la machine électrique 10 ainsi que la machine électrique 10 elle-même, et non sur une chaîne partielle qui ne comprendrait que la machine électrique 10. En outre, la calibration est réalisée pour un point de fonctionnement particulier qui est représentatif de conditions de fonctionnement de la machine électrique 10 lors de son utilisation. Ainsi, le modèle d'estimation une fois calibré permet une estimation précise du couple fourni par la machine électrique 10 lors de son fonctionnement ultérieur, à partir d'une mesure du courant électrique en entrée de la machine.

Le procédé de calibration du modèle d'estimation du couple permet de réduire, voire d'annuler, les imprécisions liées à la mesure indirecte du couple par le biais d'une mesure de courant électrique, notamment l'incertitude liée à la mesure du courant électrique elle-même et aux tolérances de fabrication de la machine électrique 10. Le couple fourni par la machine électrique 10 est donc estimé avec une incertitude réduite, qui est notamment compatible de l'utilisation de la machine électrique 10 pour de la propulsion aéronautique. En effet, la calibration du modèle d'estimation du couple permet de satisfaire aux impératifs de sécurité du vol, du fait de la précision améliorée de la mesure du couple, en permettant de faire se correspondre de manière précise un courant électrique de la machine en entrée, et un couple de la machine fourni en sortie. Le couple fourni par la machine électrique 10 peut être ainsi mieux maitrisé. Cette maitrise permet un contrôle de la machine électrique 10 plus précis, de sorte que le couple fourni par la machine électrique 10 au cours des différentes phases de vol, soit maximisé, tout en étant assuré de ne pas dépasser le couple maximum pour lequel la chaine de transmission mécanique a été conçue et ainsi ne pas risquer de l'endommager.

### Dispositif de calibration

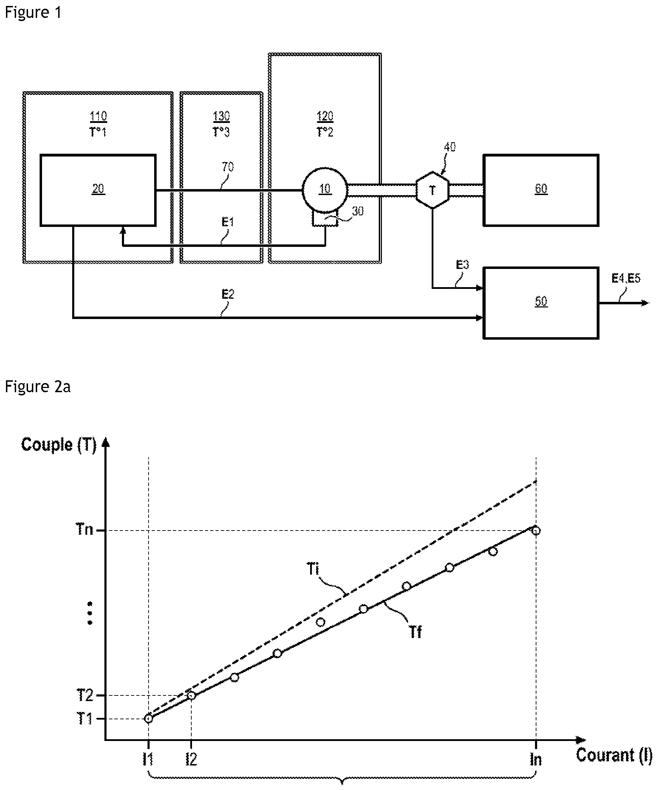

Un dispositif de calibration pour l'estimation d'un couple fourni par une machine électrique 10, notamment par un moteur à aimants permanents, est illustré à titre d'exemple non limitatif en figure 1. Le dispositif de calibration comprend :
- un dispositif de mesure d'un courant électrique 30 adapté pour mesurer le courant électrique dans la machine électrique 10 pour un point de fonctionnement de la machine électrique 10 ; avantageusement, un dispositif de mesure du courant électrique 30 déjà présent dans la machine électrique 10 (et pouvant donc être utilisé dans d'autres process relatifs à la machine électrique 10) peut être utilisé, ce qui permet de ne pas augmenter l'encombrement ni la masse de la machine électrique 10 ;
- un modèle d'estimation associant un couple de sortie à un courant électrique d'entrée, de sorte que le modèle d'estimation est adapté pour estimer un couple fourni par la machine électrique 10 pour ledit point de fonctionnement de la machine électrique 10, à partir du courant électrique mesuré par le dispositif de mesure 30 ;
- une unité de calibration 50 comprenant un couplemètre 40 adapté pour mesurer un couple de référence fourni par la machine électrique 10 pour le point de fonctionnement de la machine électrique 10 ; et adaptée pour comparer le couple estimé avec le couple de référence, l'unité de contrôle 50 étant en outre adaptée pour ajuster le modèle d'estimation en fonction de ladite comparaison, de sorte à réduire, voire annuler, une différence entre le couple estimé et le couple de référence ; et
- un banc d'essai 60 adapté pour recevoir la machine électrique 10 pour la calibration du modèle d'estimation du couple.

Le couplemètre 40 peut notamment être intégré au banc d'essai 60. Dans tous les cas, il n'est pas nécessaire d'intégrer le couplemètre à la machine électrique 10 elle-même, le couplemètre 40 intégré au banc d'essai 60 au sol suffisant à calibrer le modèle d'estimation du couple fourni par la machine électrique 10.

Le dispositif de mesure du courant électrique 30 correspond au capteur de courant prévu pour l'application. Ce peut être en pratique un capteur à effet Hall, un shunt, un capteur magnéto-résistif, ou un capteur à vanne de flux (« fluxgate » en anglais). Le type de dispositif de mesure du courant électrique 30 est choisi en fonction de différents critères, tels que : la précision de la mesure souhaitée, l'espace disponible pour l'intégration ; le coût du dispositif de mesure du courant électrique 30. Par exemple, on a vu qu'un capteur à effet Hall présente un encombrement et un coût moindres, mais une précision plus limitée, qu'un capteur à vanne de flux. C'est un objet de la demande que de permettre l'utilisation d'un capteur de mesure du courant de précision et coût moindres, tel qu'un capteur à effet Hall, par un procédé et un dispositif de calibration du modèle d'estimation du couple à partir de cette mesure de courant.

En pratique, le dispositif de mesure du courant électrique 30 peut être situé au niveau de la machine électrique 10, ou au niveau du système de contrôle 20. Le courant électrique mesuré correspond au courant électrique circulant dans une phase de la machine électrique 10, au point de fonctionnement.

Le dispositif de calibration est adapté pour la mise en œuvre du procédé décrit ci-dessus, et offre donc les mêmes avantages de précision de calibration sans augmentation du coût, de la masse ou de l'encombrement du système que le procédé décrit ci-dessus.

Le système de contrôle 20 de la machine électrique 10 est adapté pour commander une vitesse de rotation et une tension d'alimentation de la machine électrique 10. Le système de contrôle 20 de la machine électrique 10 comprend en pratique une électronique de contrôle et une électronique de puissance de la machine électrique 10.

L'électronique de puissance comprend des moyens de contrôle du courant électrique circulant dans la machine électrique 10 qui sont adaptés au type de machine électrique 10, tels qu'un convertisseur de puissance, par exemple un onduleur ou un redresseur. L'électronique de contrôle permet de contrôler l'électronique de puissance.

Le procédé décrit ci-dessus permet de réaliser la calibration sur l'ensemble du système comprenant la chaine électronique/électrique de puissance complète, du système de contrôle 20 au moteur électrique 10 - y compris le harnais de puissance le cas échéant. Par conséquent, les incertitudes sur l'ensemble du système sont réduites, et non simplement les incertitudes sur la machine électrique 10 ou le système de contrôle 20 de la machine électrique 10 uniquement.

Le procédé peut comprendre en outre une étape E6 d'enregistrement du modèle d'estimation ajusté dans une mémoire du système de contrôle 20.

Les étapes E1 à E4 peuvent être répétées pour plusieurs points de fonctionnement différents de la machine électrique 10. Chaque point de fonctionnement peut être défini par un ou plusieurs paramètres de la machine électrique, comprenant notamment une température, une vitesse de rotation, et une tension d'alimentation de la machine électrique. Autrement dit chaque point de fonctionnement est défini par une valeur donnée ou une combinaison (n-uplet) de valeurs de paramètres de fonctionnement de la machine électrique.

De manière plus détaillée, pour chaque point de fonctionnement de la machine électrique 10, le procédé de calibration comprend les étapes suivantes :
un courant électrique en entrée de la machine électrique 10 sur le banc d'essai 60 est mesuré à l'étape E1, un couple fourni par la machine électrique 10 est estimé à l'étape E2, un couple de référence est mesuré par le couplemètre du banc d'essai 60 à l'étape E3, et le couple estimé est comparé avec le couple de référence à l'étape E4. En particulier, différents points de fonctionnement de la machine électrique 10 peuvent correspondre à différents courants électriques dans la machine électrique 10. Par conséquent, la répétition des étapes E1 à E4 pour différents points de fonctionnement permet d'estimer différents couples, correspondant chacun aux différents courants électriques mesurés. Ainsi, la calibration est plus précise, et tient compte de différentes conditions de fonctionnement de la machine électrique 10. Plus les points de fonctionnement sont nombreux, plus la calibration du modèle d'estimation du couple est précise et la robustesse du modèle d'estimation du couple est améliorée.

Le procédé de calibration du modèle d'estimation du couple fourni par la machine électrique 10 peut être réalisé après la réception de la machine électrique 10, et avant que la machine électrique 10 ne soit intégrée au système propulsif (aéronef) auquel elle doit fournir de l'énergie. Autrement dit la calibration du modèle d'estimation est réalisée au sol, à l'aide de l'unité de calibration 50 (sur le banc d'essai 60) ; Cette calibration du modèle d'estimation de couple est ce qui permet, en vol, de disposer d'une estimation précise du couple fourni par la machine électrique 10 sur la base des paramètres d'entrée de l'estimateur : courant notamment, voire tension d'alimentation et/ou température comme il sera expliqué , garantissant un couple optimal pour chaque phase de vol, en termes d'efficacité propulsive et en termes de sécurité de vol.

Dans le cas où dans l'application (l'aéronef) concernée, un harnais de puissance 70, c'est-à-dire un ensemble de câbles électriques aptes à transporter les signaux de puissance entre le système de contrôle 20, déporté, et la machine électrique 10 elle-même, on prévoit que le dispositif et le procédé de calibration intègrent un tel harnais de puissance 70 afin de tenir compte de tout l'ensemble formé par la chaine électronique/électrique de puissance complète (du système de contrôle 20 au moteur électrique 10).

### Estimation du couple (étape E2)

L'estimation du couple fourni par la machine est réalisée à l'étape E2 à partir du courant électrique mesuré à l'étape E1 et d'un modèle d'estimation associant un couple de sortie à un courant électrique d'entrée par l'unité de calibration 50.

Une plage de courant électrique globale [I1, In] comprend l'ensemble des courants électriques susceptibles d'être appliqués en entrée de la machine électrique 10 en fonctionnement, c'est-à-dire pendant les différentes phases de vol de l'aéronef ; il s'agit donc de l'ensemble des courants électriques mesurés lors de l'étape E1.

La calibration du modèle d'estimation est de préférence réalisée sur l'ensemble de la plage de courant électrique globale [I1, In], pour obtenir la meilleure précision sur toute la plage de fonctionnement de la machine (toutes les phases de vol). L'ajustement du modèle d'estimation effectué à l'étape E5 sur la plage de courant électrique globale [I1, In], permet de minimiser une différence entre l'ensemble des couples estimés et l'ensemble des couples de référence.

Dans une variante, la calibration du modèle d'estimation peut être réalisée sur une plage de courant électrique prédéterminée [Ik, In], qui est une plage réduite et comprise dans la plage de courant électrique globale [I1, In]. De la sorte, on permet une calibration particulièrement précise sur cette plage réduite, car spécifiquement optimisée pour cette plage réduite. Une telle plage de courant électrique prédéterminée [Ik, In] réduite par rapport à la plage de courant électrique globale [I1, ..., In], comprendra typiquement une sélection des courants électriques mesurés lors de l'étape E1.. L'ajustement du modèle d'estimation effectué à l'étape E5 s'applique alors à la plage de courant électrique prédéterminée [Ik, In], c'est-à-dire que cette étape E5 prend en compte les couples estimés à partir des courants électriques mesurés qui sont compris dans cette plage ; et ne prend pas en compte les couples estimés à partir de courants électriques mesurés situés en dehors de la plage de courant électrique prédéterminée [Ik, In]. On obtient ainsi une calibration particulièrement précise dans la plage de courant électrique prédéterminée [Ik, In] ; mais moins précise en dehors de cette plage [Ik, In].

La plage de courant électrique prédéterminée [Ik, In] peut correspondre à une plage de fonctionnement préférée de la machine électrique 10, ou à une plage de courant de fonctionnement critique de la machine électrique 10, dans laquelle la calibration doit être particulièrement précise. Par exemple, dans le domaine de la propulsion aéronautique, le besoin en précision est particulièrement présent près du couple maximum, donc près du courant électrique maximum susceptible d'être appliqué à la machine électrique 10 en fonctionnement. En effet, le dimensionnement de la transmission de puissance et la puissance maximum correspond à une plage de couple située à proximité du couple maximum. Ainsi, la plage de courant électrique prédéterminée [Ik, In] peut correspondre à une plage de courant électrique comprise entre 90 et 100% de la valeur de courant maximum pour la machine électrique 10 considérée, qui correspond à une plage de couple entre 80 et 100% de la valeur de couple maximum définie pour la chaine de propulsion considérée.

Le procédé et le dispositif de calibration présentés, permettent donc de calibrer un modèle d'estimation défini pour un moteur électrique et une chaine propulsive donnée.

### Calibration du modèle d'estimation

Plusieurs modèles d'utilisation peuvent être utilisés.

### Modèle d'estimation basé sur une fonction affine

Le modèle d'estimation à calibrer peut dans un premier exemple, être une fonction affine, c'est-à-dire une loi qui est une fonction linéaire du courant électrique mesuré, et qui lie le couple de sortie au courant électrique d'entrée. Une telle fonction affine est définie par deux paramètres, une ordonnée à l'origine et une pente.

Le procédé et le dispositif de calibration d'une telle fonction affine permettent d'ajuster les paramètres de la fonction affine.

A cette fin, des valeurs initiales de ces paramètres, ordonnée à l'origine et pente, définissent une fonction affine initiale enregistrés dans une mémoire de l'unité de calibration 50 au cours de l'étape E6, et le procédé de calibration permet d'obtenir une fonction affine finale, à partir des mesures de couple de référence pour différentes mesures de courant d'entrée correspondant à différents points de fonctionnement de la machine.

On note Tini, lafonction affine initiale Tini du modèle d'estimation à calibrer. La fonction affine initiale Tini est définie par une ordonnée à l'origine initiale Bini et une pente initiale Ktini, et fournit une valeur de couple Tini(x) à partir d'un courant d'entrée mesuré I0par application de l'équation EQ1 : Tini (x)= Ktini * lini + Bi.

L'ajustement du modèle d'estimation réalisé à l'étape E5 comprend un ajustement de la pente initiale Ktini et/ou de l'ordonnée à l'origine initiale Bini de la fonction affine initiale Tini. Plus particulièrement, les valeurs des paramètres de et/ou d'ordonnée à l'origine de la fonction affine initiale Tini peuvent être recalées en comparant les couples estimés de référence mesurés et, pour différents points de fonctionnement de la machine, de sorte qu'une distance totale des couples estimés aux couples de référence T1, ..., Tn mesurés correspondants soit minimisée, voire soit annulée. On obtient une fonction affine finale Tfin obtenue par calibration du modèle d'estimation, définit par les nouveaux paramètres Ktfin et/ou Bfin, tels qu'on obtient une valeur estimée de couple plus précise, notée T*, pour la mesure de courant électrique Ii (pour i nombre entier allant de 1 (ou k en cas de plage réduite) à n, et n étant le nombre de points de fonctionnement utilisés). Cette valeur T* est donnée par : T* = Ktfin * Ii + Bfin.

La fonction affine finale Tfin, peut être en pratique obtenue en effectuant une régression linéaire sur l'ensemble des couples de référence mesurés à l'étape E3, ou sur une sélection de couples de référence de cet ensemble, correspondant à une plage d'intérêt comme expliqué supra.

La figure 2a illustre à titre d'exemple non limitatif un modèle d'estimation qui est ajusté à l'étape E5 de sorte à minimiser la distance entre les couples estimés à l'étape E2 et les couples de référence T1, ..., Tn mesurés à l'étape E3, sur la plage de courant lectrique globale [I1, In]. Partant de l'ensemble des différents couples estimés par la fonction affine initiale Tini et, la fonction affine finale Tfin est obtenue en effectuant une régression linéaire sur l'ensemble des couples de référence mesurés T1, ... Tn correspondants. L'ordonnée à l'origine et/ou la pente de la fonction affine d'estimation de couple sont ainsi ajustés de sorte que la fonction affine finale Tfin corresponde à la régression linéaire sur l'ensemble des couples de référence mesurés T1, ... Tn sur la plage de courant électrique globale [I1, In] considérée.

La figure 2b illustre à titre d'exemple non limitatif un modèle d'estimation qui est ajusté à l'étape E5 de sorte à minimiser la distance entre une sélection de couples estimés à l'étape E2 sur la plage de courant électrique prédéterminée [Ik, In] correspondant à une plage d'intérêt, et une sélection correspondante des couples de référence Tk, ..., Tn mesurés à l'étape E3 sur la plage de courant électrique prédéterminée [Ik, In]. La fonction affine finale Tfin est obtenue en effectuant une régression linéaire sur la sélection des couples de référence mesurés Tk, ..., Tn pour la plage de courant électrique prédéterminée [Ik, In]. L'ordonnée à l'origine initiale Bi et/ou la pente initiale Ktini de la fonction affine d'estimation de couple sont ainsi ajustées de sorte que la fonction affine finale Tfin corresponde à la régression linéaire sur la sélection de couples de référence mesurés Tk, ... Tn pour les courants électriques situés dans la plage de courant électrique prédéterminée [Ik, In] considérée. Ainsi, la calibration du modèle d'estimation de couple est particulièrement précise sur la plage de courant électrique prédéterminée [Ik, In] d'intérêt.

### Modèle d'estimation basé sur une fonction polynomiale

Dans un autre exemple, le modèle d'estimation est basé sur une fonction polynomiale de degré strictement supérieur à 1, par exemple une fonction quadratique, ou une fonction cubique. Le modèle d'estimation est adapté pour estimer le couple de sortie, en fonction du courant électrique d'entrée et en fonction de coefficients associés à chaque degré de la fonction polynomiale. Le modèle d'estimation comprend donc des paramètres correspondant aux coefficients associés à chaque degré de la fonction polynomiale. Ces paramètres sont ensuite enregistrés dans la mémoire du système de contrôle 20 de la machine électrique 10 au cours de l'étape E6.

Une telle fonction polynomiale de degré strictement supérieur à 1 permet de prendre en compte des non-linéarités dans l'estimation du couple à partir du courant électrique, par exemple lorsque la constante de couple de la machine électrique 10 dépend du courant électrique. En effet, on observe généralement un affaiblissement de la constante de couple lorsque la machine électrique arrive dans le « coude de saturation magnétique, proche du courant maximum. L'ajustement à l'étape E5 des paramètres de la fonction polynomiale de degré strictement supérieur à 1 peut être réalisé sur la plage de courant électrique globale [I1, In], ou sur une plage de courant électrique prédéterminée [Ik, In], plus restreinte, et plus particulièrement d'intérêt de manière similaire à ce qui est décrit ci-dessus concernant la fonction affine.

### Modèle d'estimation basé sur toute autre fonction reliant le courant électrique mesuré au couple estimé

De manière plus générale, le modèle d'estimation comprend toute fonction permettant d'estimer un couple fourni par la machine électrique 10 à partir d'une mesure de courant électrique dans la machine électrique 10. Le modèle d'estimation comprend le ou les paramètres qui définissent la fonction reliant le courant électrique mesuré au couple estimé. Ces paramètres peuvent être enregistrés dans la mémoire du système de contrôle 20 au cours de l'étape E6, et ajustés de manière similaire à ce qui a été présenté et décrit ci-dessus.

### Modèle d'estimation basé sur une table de correspondance

Dans encore un autre exemple, le modèle d'estimation comprend une table de correspondance associant à chacun d'une pluralité de courants électriques d'entrée, un couple de sortie estimé correspondant. La table de correspondance du modèle d'estimation comprend ainsi une pluralité de courants électriques d'entrée, et une pluralité de couples de sortie estimés correspondants. L'ajustement du modèle d'estimation réalisé à l'étape E5 comprend alors un ajustement d'une ou d'une pluralité de courant électrique d'entrée et/ou de couple de sortie associé de la table de correspondance. En d'autres termes, une ou plusieurs valeurs de couple de sortie de la table de correspondance sont recalées lors de l'étape E5 en fonction de la comparaison entre le couple estimé et le couple de référence effectuée à l'étape E4, de sorte à réduire voire annuler une différence entre le couple estimé et le couple de référence. Ainsi, lorsque les mesures de courant relevées pendant l'essai de calibration correspondent exactement aux valeurs de courant d'entrée initiales, seules les valeurs de couples sont mises à jour ; en revanche, dans le cas contraire, à la fois les valeurs de courant d'entrée et de couple associé sont mises à jour afin que la table corresponde aux valeurs relevées pendant l'essai de calibration. L'utilisation d'une table de correspondance implique donc qu'il n'est pas nécessaire de comparer le couple estimé par la table initiale et le couple effectivement mesuré. C'est le fait de rentrer les valeurs de couple mesuré dans la table qui fait que l'erreur entre le couple estimé obtenu avec la table finale et le couple réel (mesuré) est minimisée. L'erreur est donc nécessairement nulle pour les points de fonctionnement correspondant exactement aux valeurs d'entrée de la table (courants). Entre ces points, l'erreur dépend de la fonction d'interpolation utilisée, de la distance entre les points et de la non-linéarité du couple réel sur l'intervalle entre les points de la table.

L'utilisation d'une table de correspondance permet une calibration précise de l'estimation du couple fourni par la machine électrique 10, notamment lorsque la relation entre le couple estimé et le courant électrique mesuré n'est pas facilement approximable par une fonction mathématique. La précision de la calibration dépend alors également du nombre de points de la table de correspondance (correspondant à un couple valeur de courant et valeur de couple mesurés). Plus la table de correspondance contient un nombre important de valeurs de courants électriques d'entrées mesurés associés aux couples estimés de sortie pour une plage de courant électrique donnée, plus la calibration est précise.

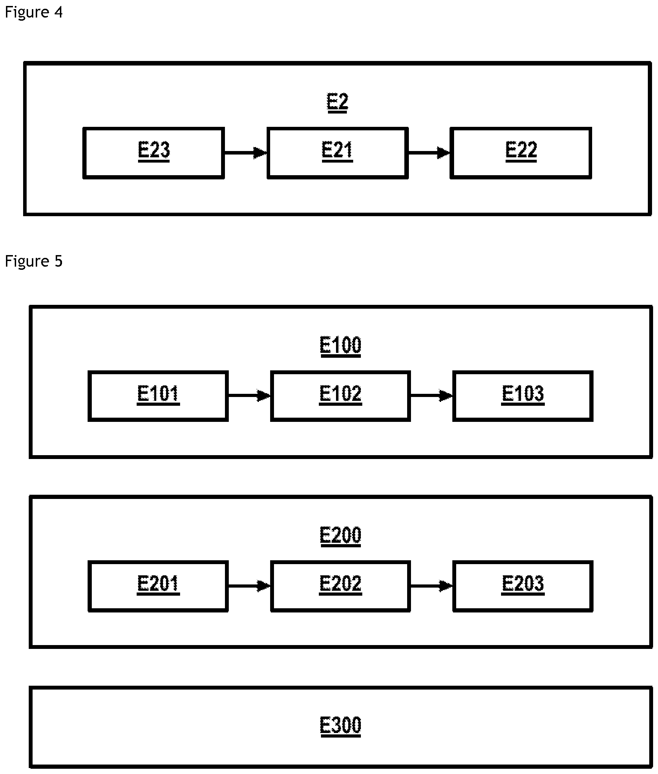

Optionnellement, ainsi qu'illustré à titre d'exemple non limitatif en figure 4, l'estimation du couple à l'étape E2 peut comprendre une sous-étape E21 de comparaison du courant électrique mesuré à l'étape E1 avec un ou plusieurs courants électriques parmi la pluralité de courants électriques d'entrée, et une sous-étape E22 d'interpolation pour en déduire le couple estimé fourni par la machine électrique 10.

Par exemple, l'interpolation de la sous-étape E22 peut être une interpolation linéaire. En particulier, si le courant électrique mesuré à l'étape E1 est situé entre un premier et un deuxième courant électrique d'entrée adjacent de la table de correspondance, alors le couple fourni par la machine électrique 10 peut être estimé par interpolation linéaire effectué entre le premier couple de sortie et le deuxième couple de sortie adjacent, associés respectivement au premier courant électrique d'entrée et au deuxième courant électrique d'entrée. Ainsi, une distance relative entre le courant électrique mesuré et le premier courant électrique d'entrée, respectivement entre le courant électrique mesuré et le deuxième courant électrique d'entrée, est égale à une distance relative entre le couple estimé et le premier couple de sortie, respectivement entre le couple estimé et le deuxième couple de sortie.

### Prise en compte d'autres variables

La table de correspondance peut être une table de correspondance à une dimension, ladite dimension correspondant au courant électrique mesuré dans la machine électrique 10. Une telle table de correspondance à une dimension permet de compenser la sensibilité du flux magnétique au courant électrique, pour augmenter la précision de l'estimation du couple fourni par la machine électrique 10. En effet, un phénomène de coude de saturation du champ induit une variation plus faible du couple pour les forts courants électriques que pour les courants électriques plus faibles.

En variante, la table de correspondance peut être une table de correspondance à plusieurs dimensions. La table de correspondance peut comprendre une première dimension correspondant au courant électrique mesuré dans la machine électrique 10, et une ou plusieurs dimensions supplémentaires correspondant :
- à une température, qui peut correspondre à une température à laquelle est soumise la machine électrique 10 et/ou à une température à laquelle est soumis le système de contrôle 20 ; et/ou
- à une tension d'alimentation et une vitesse de rotation de la machine électrique 10.

La pluralité de courants électriques d'entrée associées à la pluralité de couples de sortie est alors déterminée pour chaque température et/ou tension d'alimentation et vitesse de rotation de la table de correspondance. En d'autres termes, le modèle d'estimation comprend un ou plusieurs ensemble(s) de tables de correspondance, un premier ensemble de tables de correspondance étant associé à une température et/ou un deuxième ensemble de tables de correspondance étant associé à une tension d'alimentation et une vitesse de rotation. L'estimation du couple à l'étape E2 comprend alors une sous-étape E23 de sélection d'une table de correspondance associée à une température et/ou à une tension d'alimentation et vitesse de rotation de la machine électrique 10 au point de fonctionnement de la machine électrique pour lequel le courant électrique est mesuré à l'étape E1.

Une telle table de correspondance à plus d'une dimension permet de compenser la sensibilité de la détermination du couple fourni par la machine électrique 10 à différents facteurs environnants, tels que la variabilité de la constante de couple de la machine électrique avec la température (l'influence de la température sur le champ magnétique produit par les aimants et sur la réluctance des tôles statoriques) ou encore la variabilité de l'erreur de mesure des capteurs de courant avec la température, ce qui permet d'améliorer encore la précision de la calibration.

La température à laquelle est soumise la machine électrique 10 et/ou le système de contrôle 20 peut par exemple correspondre à une température mesurée au plus près des composants électroniques de la machine électrique 10 et/ou du système de contrôle, ou dans l'environnement extérieur proche de la machine électrique 10 et/ou du système de contrôle.

Une table de correspondance comprenant une dimension supplémentaire qui correspond à la température à laquelle est soumise la machine électrique 10 et/ou le système de contrôle 20 permet ainsi de compenser la sensibilité de la mesure du courant électrique dans la machine électrique 10 à la température et/ou l'influence de la température sur le couple fourni par la machine électrique 10 pour un courant électrique donné, et donc d'augmenter encore la précision de la calibration du modèle d'estimation du couple.

Par exemple, la table de correspondance peut être une table à deux dimensions, la deuxième dimension correspondant à la température à laquelle est soumise la machine électrique 10 et/ou le système de contrôle 20. En d'autres termes, le modèle d'estimation comprend un ensemble de tables de correspondance, chaque table de correspondance étant associée à une température parmi un ensemble de températures de fonctionnement de la machine électrique 10. L'estimation du couple à l'étape E2 comprend une étape E23 de sélection d'une table de correspondance associée à une température de la machine électrique 10 au point de fonctionnement.

L'étape E23 de sélection peut comprendre l'application d'un filtre temporel représentatif d'un modèle dynamique de l'évolution de la température. Le filtre temporel est configuré pour modéliser un écart de température entre un point de mesure de la température, typiquement des chignons des enroulements statoriques de la machine électrique 10) et un point d'intérêt pour ce paramètre de température, typiquement au niveau des aimants situés sur le rotor de la machine électrique 10. Ainsi, la table de correspondance sélectionnée correspond au mieux à la température au niveau du point d'intérêt, car influant sur la constante de couple Kt du moteur électrique, ce qui permet d'améliorer encore la précision de la calibration du modèle d'estimation du couple. Le filtre temporel modélise donc l'inertie dans la variation de la température entre le point de mesure et le point d'intérêt. Le filtre temporel peut être calibré par des mesures sur le banc d'essai 60, au moyen d'une instrumentation spécifique permettant de mesurer précisément la température au point de la mesure de température qui sera disponible (mesurable) en opérationnel (au cours des phases de vol) et au point d'intérêt.

Une table de correspondance comprenant une dimension supplémentaire qui correspond à une tension d'alimentation et une vitesse de rotation de la machine électrique 10 est notamment utile dans le cas d'une machine électrique 10 de type moteur à aimants permanents, susceptible d'être soumise en fonctionnement à de fortes variations de tension d'alimentation et/ou de vitesse de rotation. En effet, dans ce cas, on utilise généralement une commande dite de défluxage qui permet d'adapter le fonctionnement de la machine électrique 10 à différentes tensions d'alimentation et vitesses de rotation de la machine électrique 10. Le couple fourni par la machine électrique 10 dépend alors de la combinaison du niveau de tension d'alimentation et de la vitesse de rotation de la machine électrique 10. La table de correspondance peut par exemple être une table de correspondance unique dont la dimension supplémentaire correspond au rapport entre la tension d'alimentation et la vitesse de rotation, ou en variante être une table de correspondance comprenant une première dimension supplémentaire correspondant à la tension d'alimentation et une deuxième dimension supplémentaire correspondant à la vitesse de rotation.

La ou les tables de correspondance du modèle d'estimation peuvent être enregistrées dans la mémoire du système de contrôle 20 de la machine électrique au cours de l'étape E6.

La ou les tables de correspondance du modèle d'estimation sont ajustées à l'étape E5 de sorte à minimiser la distance entre les couples estimés à l'étape E2 et les couples de référence T1, ..., Tn mesurés à l'étape E3, sur la plage de courant électrique globale [I1, In], ou sur la plage de courant électrique prédéterminée [Ik, ..., In]. En d'autres termes, la modification à l'étape E5 des couples de sortie et le cas échéant des courants électriques d'entrée associés peut être réalisée sur la plage de courant électrique globale [I1, In], ou sur la plage de courant électrique prédéterminée [Ik, In], de manière similaire à ce qui est décrit ci-dessus concernant le modèle d'estimation comprenant une fonction affine.

On comprendra que la prise en compte de paramètres de fonctionnement de la machine électrique, et notamment de la température à laquelle est soumise la machine électrique 10 et/ou le système de contrôle 20, et/ou de la tension d'alimentation et de la vitesse de rotation de la machine électrique 10, en plus de la mesure de courant électrique mesuré pour fournir une valeur estimée de couple de sortie de la machine électrique, s'applique de manière similaire aux cas où la relation entre le courant et le couple peut-être modélisée par une fonction mathématique, notamment affine ou polynomiale, ou autre, dès lors que l'on dispose de mesures correspondantes. Ainsi tout ce qui a été dit au regard de la mesure et prise ne compte de la température, ou de la mesure et prise en compte de la tension d'alimentation et de la vitesse de rotation pour ce qui concerne le défluxage, s'applique de manière similaire à ces fonctions d'estimation.

Plus particulièrement, le modèle d'estimation comprend alors une fonction par exemple affine, polynomiale de degrés strictement supérieur à 1, ou de de tout autre type envisageable, comprenant une ou plusieurs variable(s) indépendantes associant à un courant électrique d'entrée mesuré, une estimation d'un couple de sortie correspondant, pour différentes valeurs ou plages de valeurs de ces paramètres additionnels. Par exemple, une première variable peut être associée à une température et/ou à une tension d'alimentation et une vitesse de rotation. L'estimation du couple à l'étape E2 comprend alors une sous-étape E23 de détermination d'une variable indépendante associée à une température et/ou d'une variable indépendante associée à une tension d'alimentation et vitesse de rotation de la machine électrique 10 au point de fonctionnement de la machine électrique 10 pour lequel le courant électrique est mesuré à l'étape E1 et/ou une variable associée au rapport entre la tension d'alimentation et la vitesse de rotation. Le modèle d'estimation permet ainsi de compenser la sensibilité de la mesure du courant électrique dans la machine électrique 10 à la température et/ou à la tension d'alimentation et vitesse de rotation, et/ou de compenser l'influence de la température et/ou de la tension d'alimentation et vitesse de rotation, sur le couple fourni par la machine électrique 10 pour un courant électrique donné, et ainsi d'augmenter encore la précision de la calibration du modèle d'estimation du couple.

### Déroulé du procédé de calibration

### Premier mode de réalisation - calibration simultanée du système électronique de contrôle 10 et de la machine électrique 10

Le procédé comprend une étape préalable d'installation de la machine électrique 10 sur un banc d'essai 60.

Le procédé comprend une étape E0 de contrôle du dispositif de calibration, en particulier de contrôle de la machine électrique 10 par le système de contrôle 20, de sorte à atteindre le point de fonctionnement.

Chaque point de fonctionnement de la machine électrique 10 peut être défini en pratique par une vitesse de rotation de la machine électrique 10 et/ou par un niveau de puissance fourni par la machine électrique 10 et/ou par une température à laquelle est soumise la machine électrique 10 et/ou par une température à laquelle est soumis le système de contrôle 20 de la machine électrique 10 et/ou par un courant électrique dans la machine électrique 10. En effet, l'estimation du couple à partir de la mesure de courant électrique, ainsi que les moyens de mesure du courant électrique, peuvent être sensibles aux conditions d'utilisation, en particulier à la température. Ainsi, un point de fonctionnement qui dépend notamment de la température permet de réaliser une calibration plus précise de l'estimation du couple.

Pour permettre l'établissement de la calibration des fonctions d'estimation ou l'établissement des tables de correspondance et tenir compte de l'influence de la température, le dispositif de calibration comprend au moins une première enceinte thermique dans laquelle est placée au moins le moteur électrique 10, permettant de réaliser les mesures de couple de référence en sortie du moteur électrique aux différents points de fonctionnement et pour différentes températures.

Le dispositif de calibration comprend de préférence au moins deux enceintes thermiques, voire trois, permettant de reproduire au mieux les conditions de température opérationnelles, pour les différents types d'installation/conception de la machine électrique 10 et son électronique de contrôle, qui peuvent être à proximité et sensiblement sous même température, ou au contraire déportées et reliées par un harnais de puissance.

Il est alors possible de placer chacun des blocs fonctionnels parmi le moteur électrique 10, le système de contrôle 20 et le harnais de puissance 70, dans les conditions de température représentatives du fonctionnement opérationnel réel :
- une première enceinte 110 adaptée pour reproduire des premières conditions extérieures, la première enceinte 110 étant adaptée pour recevoir la machine électrique 10 lors de la calibration ;
- une deuxième enceinte 120 adaptée pour reproduire des deuxièmes conditions extérieures, la deuxième enceinte 120 étant adaptée pour recevoir le système de contrôle 20 de la machine électrique 10 lors de la calibration ; et
- optionnellement, une troisième enceinte 130 adaptée reproduire des troisièmes conditions extérieures, la troisième enceinte 130 étant adaptée pour recevoir le harnais de puissance 70 lorsque le système de contrôle 20 est déporté par rapport à la machine électrique 10, le harnais de puissance 70 reliant la machine électrique 10 au système de contrôle 20. La température des câbles du harnais de puissance 70 - qui influence leur résistance électrique desdits câbles - influence en effet également le courant électrique mesuré. En prévoyant une enceinte thermique 130 propre au harnais de puissance 70 on prend donc mieux en compte l'influence, dans la mesure du courant électrique, de la température sur la résistance des câbles du harnais de puissance 70.

Les premières conditions extérieures peuvent comprendre une première température T°1. Les deuxièmes conditions extérieures peuvent comprendre une deuxième température T°2, qui peut être égale à ou différente de la première température T°1. Ainsi, les conditions reproduites dans la première enceinte 110 peuvent être identiques ou différentes de celles reproduites dans la deuxième enceinte 120. Ces deux enceintes 110, 120 permettent donc de modéliser soit le cas où la machine électrique 10 et le système de contrôle 20 sont soumis aux mêmes conditions extérieures, soit le cas où la machine électrique 10 et le système de contrôle 20 sont soumis à des conditions extérieures différentes.

Les premières conditions extérieures reproduites par la première enceinte 110 peuvent correspondre sensiblement aux conditions susceptibles d'être rencontrées par la machine électrique 10 lors de son fonctionnement. Les deuxièmes conditions extérieures reproduites par la deuxième enceinte 120 peuvent correspondre sensiblement aux conditions susceptibles d'être rencontrées par le système de contrôle 20 de la machine électrique 10 lors de son fonctionnement. Ainsi, on peut soumettre la machine électrique 10 et le système de contrôle 20 de la machine électrique 10 chacun à des conditions extérieures identiques ou différentes, représentatives de leurs conditions de fonctionnement respectives. Les troisièmes conditions extérieures peuvent comprendre une troisième température T°3, qui peut être égale ou différente de la première température T°1 et/ou de la deuxième température T°2.

Lorsque la machine électrique 10 et le système de contrôle 20 sont susceptibles d'être soumis sensiblement à des conditions extérieures identiques lors de leur fonctionnement, la machine électrique 10 et le système de contrôle 20 peuvent être placés tous deux dans la première enceinte 110, ou être placés respectivement dans la première enceinte 110 et dans la deuxième enceinte 120, les premières et deuxièmes conditions extérieures étant alors identiques. Optionnellement, lorsque le harnais de puissance 70 est également susceptible d'être soumis sensiblement à des conditions extérieures identiques à celles de la machine électrique 10 et du système de contrôle 20, le harnais de puissance 70 peut être placé dans la première enceinte 110, respectivement dans la deuxième enceinte 120, ou peut être situé dans la troisième enceinte 130, les premières, deuxièmes et troisièmes conditions extérieures étant alors identiques.

Lorsque le système de contrôle 20 est embarqué dans la machine électrique 10, ces deux blocs fonctionnels sont à proximité et on peut considérer qu'ils sont soumis à des conditions de températures homogènes.

On pourrait donc les placer dans une même enceinte 110, ou bien dans deux enceintes 110, 120 séparées, mais configurées pour reproduire des conditions extérieures, en particulier des conditions de température, sensiblement identiques, sur la plage de variation de ces conditions. Les températures auxquelles sont susceptibles d'être soumis la machine électrique 10 et le système de contrôle 20 peuvent varier sur de grandes amplitudes, par exemple en fonction :
- de la température atmosphérique ambiante, qui dans le domaine aéronautique, peut varier de -50°C à +70°C,
- de la température dans l'environnement immédiat de la machine électrique 10, qui peut être affectée par le fonctionnement d'autres matériels, par exemple la température dans un compartiment moteur tel qu'une nacelle d'avion ou un compartiment moteur d'un hélicoptère dépend fortement du fonctionnement de la turbine à gaz,
- de la température des éléments électriques et des composants électroniques de la machine électrique 10 et du système de contrôle 20, qui varie fortement avec la puissance de fonctionnement de la machine électrique 10 elle-même du fait d'un auto-échauffement provoqué par la circulation du courant électrique.

Lorsque le système de contrôle 20 de la machine électrique 10 est déporté par rapport à la machine électrique 10, un harnais de puissance 70 relie ces deux blocs fonctionnels. La machine électrique 10, le système de contrôle 20 et le harnais de puissance 70 sont alors en général soumis à des conditions de températures sensiblement différentes.

En particulier, la machine électrique 10 et ses éléments électro-magnétiques peuvent être soumis à des températures extrêmes, par exemple supérieures à 100°C, notamment lorsque la machine électrique 10 est située dans un compartiment moteur tel qu'une nacelle d'avion ou un compartiment moteur d'un hélicoptère. En revanche, le système de contrôle 20 peut être soumis à des températures moindres lorsque le système de contrôle 20 est déporté pour être placé dans un environnement plus protégé où la température est maintenue dans une plage plus faible, voire très basse, par exemple inférieure à 20°C ou inférieure à -40°C. Un point de fonctionnement de la machine électrique 10 peut par exemple être atteint pour une vitesse de rotation et/ou une tension d'alimentation données de la machine électrique 10 placée dans la première enceinte 110 reproduisant une température supérieure à 100°C, le système de contrôle 20 étant placé dans la deuxième enceinte 120 reproduisant une température inférieure à -40°C, un harnais 70 étant le cas échéant placé dans l'une parmi la première et la deuxième enceinte 110, 120 ou dans une troisième enceinte 130 dédiée, selon les conditions susceptibles d'être rencontrées par le harnais 70.

Un tel procédé de calibration à l'aide d'une ou plusieurs enceintes 110, 120, 130 comprenant la machine électrique 10 et/ou le système de contrôle 20 et/ou le harnais de puissance 70, permet de réaliser une calibration globale de l'ensemble comprenant la machine électrique 10, le système de contrôle 20 de la machine électrique 10, et le cas échéant le harnais de puissance 70 et permet de gommer au mieux les incertitudes liées à l'ensemble des paramètres environnementaux et topologiques du système, ce qui permet une calibration plus fiable, précise et facile à effectuer. En caractérisant le système de contrôle 20 et la machine électrique 10 de manière globale, le procédé de calibration est en outre simple à réaliser tout en garantissant l'obtention d'un modèle d'estimation du couple précis et robuste aux conditions d'utilisation.

### Deuxième mode de réalisation - calibration séparée du système électronique de contrôle 20 et de la machine électrique 10

Dans un deuxième exemple de réalisation, ainsi qu'illustré à titre d'exemple non limitatif en figure 5, le système électronique de contrôle 20 et la machine électrique sont calibrés séparément. Cela permet en effet de simplifier la mise en œuvre de l'invention en cas de maintenance, notamment lorsque le système de contrôle 20 est déporté et doit être remplacé en cas de panne. En particulier, il est proposé ici d'étalonner indépendamment l'un de l'autre le système de contrôle 20 et la machine électrique 10. Plus précisément, dans ce mode de réalisation, la mesure de courant du système de contrôle 20 est caractérisée à l'aide d'un système de mesure de courant étalon afin d'obtenir une table de conformation de la mesure du courant en fonction du courant réellement commandé par l'électronique de puissance du système de contrôle 20 et le cas échéant des conditions de fonctionnement pouvant affecter la précision de la mesure du courant du système de contrôle (ex : température d'environnement, tension d'alimentation, etc.) (étape E200). Cette table de conformation est donc propre à chaque système de contrôle 20. Un moteur électrique 10 peut donc être associé à n'importe quel système de contrôle 20 en chargeant simplement la table de conformation obtenue pour ce système de contrôle 20. De même, la constante de couple de la machine électrique 10 est caractérisée en fonction du courant appliqué et mesuré à l'aide du système de mesure de courant étalon et comparée à la valeur du couple mesurée à l'aide d'un outillage de test (couplemètre du banc de test) (étape E100). On obtient alors une table de conformation du couple en fonction du courant circulant dans le moteur et le cas échéant des conditions de fonctionnement. Cette table de conformation du couple est donc propre à chaque moteur électrique 10. Un système de contrôle peut ainsi être associé à n'importe quel moteur électrique 10 en chargeant simplement la table de conformation du couple obtenue pour ce moteur électrique 10.

Ainsi, en utilisant un système de référence pour la détermination du modèle d'estimation, il est alors possible d'obtenir un modèle, valable pour un moteur électrique 10 donné, mais adaptable par simple mise en correspondance à tout système électronique de contrôle, sans nécessiter de recalibrer le système électronique de contrôle lorsque celui-ci doit être changé.

A cet effet, le procédé de calibration comprend :
- une étape E100 de calibration de la machine électrique 10, comprenant une sous-étape E101 de mesure de la force électromotrice à vide de la machine électrique 10 et une sous-étape E102 de mesure d'une vitesse de rotation de la machine électrique 10, pour un point de fonctionnement de la machine électrique 10, et une sous-étape E103 de détermination d'un modèle de machine électrique associant à la force électromotrice une vitesse de rotation de la machine électrique 10, à partir de la force électromotrice et de la vitesse de rotation mesurées ;
- une étape E200 de calibration du système de contrôle 20, comprenant une sous-étape E201 de mesure d'un courant électrique de l'électronique de puissance du système de contrôle 20 sur un banc de charge statique équipé d'un capteur de courant étalon servant de référence (et le cas d'échéant, d'un harnais 70) ; une sous-étape E202 de calcul d'une erreur de mesure du courant quadratique du système de contrôle 20 par rapport au capteur de courant étalon servant de référence. Ces mesures peuvent être réalisées pour différentes consignes de courant afin de couvrir une plage de courant d'intérêt, optionnellement pour différentes conditions d'utilisation pouvant affecter la précision de la mesure du courant du système de contrôle (ex : température d'environnement, tension d'alimentation, etc.). Avantageusement, la mesure du courant de référence sur un banc de charge statique permet d'obtenir des mesures robustes et très précises ; et une sous-étape E203 de création d'un modèle de conformation associant la mesure de courant de référence en fonction du courant réellement commandé par l'électronique de puissance, et optionnellement des conditions de fonctionnement (température, vitesse de rotation, etc.), afin de déterminer des paramètres de correction du courant électrique commandé par l'électronique de puissance du système de contrôle 20 à partir du courant mesuré par le capteur de courant étalon servant de référence ; et
- une étape E300 d'enregistrement dans l'unité de contrôle 50 du modèle de machine électrique et du modèle de conformation dans une mémoire du système de commande 20.

La calibration de la machine électrique 10 à l'étape E100, respectivement du système de contrôle 20 à l'étape E200, reste donc valide lorsque le système de contrôle 20, respectivement la machine électrique 10, est changé, par exemple en cas de panne du système de contrôle 20, respectivement de la machine électrique 10. Notamment, dans le cas où le système de contrôle 20 est déporté de la machine électrique 10, le système de contrôle 20 peut être amené à être souvent changé lors du service du système, et ce indépendamment de la machine électrique 10. Le système de commande peut ainsi être associé à n'importe qu'elle machine électrique, moyennant le chargement de la table de conformation de l'estimateur de couple associé à la machine pilotée

Le modèle d'estimation est défini en prenant en compte de manière indépendante le modèle de machine électrique et le modèle de système de contrôle. Le modèle d'estimation peut correspondre à la somme du modèle de machine électrique et du modèle de système de contrôle. L'unité de contrôle 50 peut ainsi être associée à n'importe quelle machine électrique 10 et/ou à n'importe quel système de contrôle 20, moyennant le changement du modèle de machine électrique ou du modèle de système de contrôle en cas de remplacement de la machine électrique 10 ou du système de contrôle 20.

La mesure de la force électromotrice à vide est réalisée à la sous-étape E101 en pilotant la machine électrique 10 à vide, c'est-à-dire sans charge, afin de recueillir la donnée de la force électromotrice à vide, le cas échéant en fonction de la température de la machine électrique 10. Plusieurs mesures de force électromotrice à différentes températures de fonctionnement de la machine électrique 10 peuvent être réalisées, afin d'obtenir une table de forces électromotrices en fonction de la température.

La force électromotrice (FEM) se traduit par la tension générée par la machine électrique 10 quand la machine électrique 10 est entraînée en rotation à une certaine vitesse. Le lien entre la vitesse de rotation de la machine électrique 10 et la force électromotrice est identique au lien entre le courant électrique et le couple.

La calibration de la machine électrique 10 est donc réalisée à l'étape E100 en identifiant le lien entre la vitesse de rotation de la machine électrique 10 et la force électromotrice, qui permet d'en déduire de façon précise le lien entre le courant électrique mesuré et le couple fourni par la machine électrique 10, ces liens étant identiques. En d'autres termes, à partir de l'estimation du lien entre courant et couple, via la mesure de la force électromotrice, et de la mesure de courant de référence par le capteur de courant étalon servant de référence sur le banc de charge statique, il est possible de construire le modèle d'estimation de couple (table ou fonction). Le modèle de machine électrique déterminé à la sous-étape E103 comprend un ou plusieurs paramètres associant au courant électrique mesuré un couple fourni par la machine électrique 10, le cas échéant en fonction en outre d'autres paramètres de fonctionnement, tels que la température, un courant de quadrature, etc.

La sous-étape E201 de mesure du courant électrique dans la machine électrique 10 peut comprendre trois mesures de courant électrique la, Ib et Ic, qui sont les courants circulant dans chaque phase de la machine électrique 10. Le courant électrique de référence Iq peut être calculé, de manière connue en soi, à partir de ces trois mesures de courant électrique Iq = fonction (la, Ib, Ic), cette fonction étant une matrice 3x3 qui dépend de la mesure de position du rotor de la machine électrique (transformée de Park). Ainsi, la mesure de courant électrique est reconstituée par calcul à partir de mesures de courant de phase de la machine électrique 10.

Le modèle de système de contrôle associe au courant électrique mesuré le courant de quadrature calculé et le courant électrique commandé par le système de contrôle 20 : Imes = fonction (Iq, Iref).

Le modèle de système de contrôle créé à la sous-étape E203 peut en outre associer au courant électrique mesuré une température du système de contrôle 20 : Imes = fonction (Iq, Iref, T°2).

Lorsque le système de contrôle 20 (ou éventuellement la machine électrique 10) est remplacé, l'ancien modèle de système de contrôle est remplacé par le nouveau modèle de système de contrôle (respectivement, de machine électrique), qui est obtenu par la calibration du nouveau système de contrôle 20 à l'étape E200 (respectivement, de la nouvelle machine électrique à étape E100).

Les paramètres de calibration du modèle de machine électrique peuvent être mémorisés dans une mémoire du système de contrôle 20 prévu pour la machine électrique 10. Ainsi, il est simple de programmer le système de contrôle 20 qui doit être appairé avec la machine électrique 10, avec les paramètres de calibration de la mesure de courant.

En option, et pour les paramètres de calibration de la machine électrique 10 elle-même, en particulier le coefficient de couple Kt, on prévoit avantageusement d'attacher physiquement une carte mémoire à la machine électrique 10, avec une interface ad hoc entre cette carte et le système de contrôle 20, pour enregistre ces paramètres.

D'autres modes de réalisation peuvent être envisagés et une personne du métier peut facilement modifier les modes ou exemples de réalisation exposés ci-dessus ou en envisager d'autres tout en restant dans la portée des revendications de la présente demande.

## Revendications

1. Procédé de calibration d'un modèle d'estimation d'un couple fourni par une machine électrique (10), notamment par un moteur à aimants permanents, comprenant les étapes suivantes :
E1 : mesure d'un courant électrique dans la machine électrique (10) pour un point de fonctionnement de la machine électrique (10) ;
E2 : estimation du couple fourni par la machine électrique (10) pour ledit point de fonctionnement de la machine électrique (10), à partir du courant électrique mesuré et du modèle d'estimation associant un couple de sortie à un courant électrique d'entrée ;
E3 : mesure d'un couple de référence fourni par la machine électrique (10) pour ledit point de fonctionnement de la machine électrique (10) ;
E4 : comparaison du couple estimé avec le couple de référence ; et
E5 : en fonction de ladite comparaison, ajustement du modèle d'estimation de sorte à réduire, voire annuler, une différence entre le couple estimé et le couple de référence.

2. Procédé de calibration selon la revendication 1, comprenant en outre une étape E6 d'enregistrement du modèle d'estimation ajusté dans une mémoire d'un système de contrôle (20).

3. Procédé de calibration selon l'une quelconque des revendications 1 et 2, dans lequel les étapes E1 à E4 sont répétées pour plusieurs points de fonctionnement différents de la machine électrique (10).

4. Procédé de calibration selon l'une quelconque des revendications 1 à 3, dans lequel le modèle d'estimation comprend une fonction affine, et dans lequel l'ajustement du modèle d'estimation comprend un ajustement d'une pente et/ou d'une ordonnée à l'origine de la fonction affine.

5. Procédé de calibration selon l'une quelconque des revendications 1 à 3, dans lequel le modèle d'estimation comprend une table de correspondance associant à chacun d'une pluralité de courants électriques d'entrée un couple de sortie correspondant, et dans lequel l'estimation du couple à l'étape E2 comprend un recalage d'au moins une valeur de couple de sortie de la table de correspondance lors de l'étape E5 en fonction de la comparaison entre le couple estimé et le couple de référence effectuée à l'étape E4, de sorte à réduire voire annuler la différence entre le couple estimé et le couple de référence.

6. Procédé de calibration selon la revendication 5, dans lequel le modèle d'estimation comprend un ensemble de tables de correspondance, chaque table de correspondance étant associée à une température parmi un ensemble de températures de fonctionnement de la machine électrique (10), et dans lequel l'estimation du couple à l'étape E2 comprend une sous-étape (E23) de sélection d'une table de correspondance associée à une température de la machine électrique (10) au point de fonctionnement.

7. Procédé de calibration selon l'une quelconque des revendications 1 à 6, dans lequel le modèle d'estimation est ajusté de sorte à réduire, voire annuler, une différence entre le couple estimé et le couple de référence, sur une plage de courant électrique prédéterminée [Ik, In], et/ou pour une plage de température de fonctionnement prédéterminée.

8. Procédé de calibration selon l'une quelconque des revendications 1 à 7, comprenant :
- une étape (E100) de calibration de la machine électrique (10), comprenant une sous-étape (E101) de mesure de la force électromotrice à vide de la machine électrique (10) et une sous-étape (E102) de mesure d'une vitesse de rotation de la machine électrique (10), pour un point de fonctionnement de la machine électrique (10), et une sous-étape (E103) de détermination d'un modèle de machine électrique associant à la force électromotrice une vitesse de rotation de la machine électrique (10), à partir de la force électromotrice et de la vitesse de rotation mesurées ;
- une étape (E200) de calibration du système de contrôle (20), comprenant une sous-étape (E201) de mesure d'un courant électrique dans le système de contrôle (20) sur un banc de charge statique équipé d'un capteur de courant étalon pour obtenir une mesure de courant de référence, une sous-étape (E202) de calcul d'une erreur de mesure du courant quadratique du système de contrôle (20) par rapport à la mesure du courant de référence, et une sous-étape (E203) de création d'un modèle de conformation afin de corriger la mesure de courant commandé par le système de contrôle (20) à partir de la mesure du courant de référence; et
- une étape (E300) d'enregistrement dans l'unité de contrôle (50) du modèle de machine électrique et du modèle de conformation du système de contrôle.

9. Dispositif de calibration pour l'estimation d'un couple fourni par une machine électrique (10), notamment par un moteur à aimants permanents, comprenant :
- un dispositif de mesure d'un courant électrique adapté pour mesurer le courant électrique dans la machine électrique (10) pour un point de fonctionnement de la machine électrique (10) ;
- un modèle d'estimation associant un couple de sortie à un courant électrique d'entrée, de sorte que le modèle d'estimation est adapté pour estimer un couple fourni par la machine électrique (10) pour ledit point de fonctionnement de la machine électrique (10), à partir du courant électrique mesuré ;
- un couplemètre (40) adapté pour mesurer un couple de référence fourni par la machine électrique (10) pour ledit point de fonctionnement de la machine électrique (10) ; et
- une unité de contrôle (50) adaptée pour comparer le couple estimé avec le couple de référence, l'unité de contrôle (50) étant en outre adaptée pour ajuster le modèle d'estimation en fonction de ladite comparaison, de sorte à réduire, voire annuler, une différence entre le couple estimé et le couple de référence.

10. Dispositif de calibration selon la revendication 9, comprenant en outre :
- une première enceinte (110) adaptée pour reproduire des premières conditions extérieures, la première enceinte (110) étant adaptée pour recevoir la machine électrique (10) lors de la calibration ; et
- une deuxième enceinte (120) adaptée reproduire des deuxièmes conditions extérieures, la deuxième enceinte (120) étant adaptée pour recevoir le système de contrôle (20) de la machine électrique (10) lors de la calibration.

## Patentansprüche

1. Verfahren zur Kalibrierung eines Modells zur Schätzung eines von einer elektrischen Maschine (10), insbesondere von einem Motor mit Permanentmagneten, gelieferten Drehmoments, umfassend die folgenden Schritte:
E1: Messen eines elektrischen Stroms in der elektrischen Maschine (10) für einen Betriebspunkt der elektrischen Maschine (10);
E2: Schätzen des von der elektrischen Maschine (10) für den Betriebspunkt der elektrischen Maschine (10) gelieferten Drehmoments anhand des gemessenen elektrischen Stroms und des Schätzmodells, das einem elektrischen Eingangsstrom ein Ausgangsdrehmoment zuordnet;
E3: Messen eines von der elektrischen Maschine (10) für den Betriebspunkt der elektrischen Maschine (10) gelieferten Referenzdrehmoments;
E4: Vergleichen des geschätzten Drehmoments mit dem Referenzdrehmoment; und
E5: Anpassen, in Abhängigkeit von dem Vergleich, des Schätzmodells derart, dass eine Differenz zwischen dem geschätzten Drehmoment und dem Referenzdrehmoment verringert, ja sogar aufgehoben wird.

2. Kalibrierungsverfahren nach Anspruch 1, das ferner einen Schritt des Speicherns E6 des angepassten Schätzmodells in einem Speicher eines Steuersystems (20) umfasst.

3. Kalibrierungsverfahren nach einem der Ansprüche 1 und 2, wobei die Schritte E1 bis E4 für mehrere verschiedene Betriebspunkte der elektrischen Maschine (10) wiederholt werden.

4. Kalibrierungsverfahren nach einem der Ansprüche 1 bis 3, wobei das Schätzmodell eine affine Funktion umfasst, und wobei die Anpassung des Schätzmodells eine Anpassung einer Steigung und/oder einer Ordinate am Ursprung der affinen Funktion umfasst.

5. Kalibrierungsverfahren nach einem der Ansprüche 1 bis 3, wobei das Schätzmodell eine Zuordnungstabelle umfasst, die jedem von einer Vielzahl von elektrischen Eingangsströmen ein entsprechendes Ausgangsdrehmoment zuordnet, und wobei die Schätzung des Drehmoments in Schritt E2 eine Neukalibrierung mindestens eines Ausgangsdrehmomentwerts der Zuordnungstabelle in Schritt E5 in Abhängigkeit von dem in Schritt E4 durchgeführten Vergleich zwischen dem geschätzten Drehmoment und dem Referenzdrehmoment derart umfasst, dass die Differenz zwischen dem geschätzten Drehmoment und dem Referenzdrehmoment verringert, ja sogar aufgehoben wird.

6. Kalibrierungsverfahren nach Anspruch 5, wobei das Schätzmodell eine Reihe von Zuordnungstabellen umfasst, wobei jede Zuordnungstabelle einer Temperatur aus einer Reihe von Betriebstemperaturen der elektrischen Maschine (10) zugeordnet ist, und wobei die Schätzung des Drehmoments in Schritt E2 einen Unterschritt (E23) des Auswählens einer Zuordnungstabelle umfasst, die einer Temperatur der elektrischen Maschine (10) am Betriebspunkt zugeordnet ist.

7. Kalibrierungsverfahren nach einem der Ansprüche 1 bis 6, wobei das Schätzmodell derart angepasst wird, dass eine Differenz zwischen dem geschätzten Drehmoment und dem Referenzdrehmoment in einem vorbestimmten Strombereich [Ik, In] und/oder für einen vorbestimmten Betriebstemperaturbereich verringert, ja sogar aufgehoben wird.

8. Kalibrierungsverfahren nach einem der Ansprüche 1 bis 7, umfassend:
- einen Kalibrierungsschritt (E100) der elektrischen Maschine (10), der einen Unterschritt (E101) des Messens der elektromotorischen Kraft im Leerlauf der elektrischen Maschine (10) und einen Unterschritt (E102) des Messens einer Drehzahl der elektrischen Maschine (10) für einen Betriebspunkt der elektrischen Maschine (10) und einen Unterschritt (E103) des Bestimmens eines Modells der elektrischen Maschine umfasst, das der elektromotorischen Kraft eine Drehzahl der elektrischen Maschine (10) zuordnet, anhand der gemessenen elektromotorischen Kraft und der gemessenen Drehzahl;
- einen Kalibrierungsschritt (E200) des Steuersystems (20), der einen Unterschritt (E201) des Messens eines elektrischen Stroms im Steuersystem (20) auf einem statischen Lastprüfstand, der mit einem Eichstromsensor ausgestattet ist, um eine Referenzstrommessung zu erhalten, einen Unterschritt (E202) des Berechnens eines quadratischen Strommessfehlers des Steuersystems (20) in Bezug auf die Referenzstrommessung und einen Unterschritt (E203) des Erstellens eines Konformationsmodells umfasst, um die vom Steuersystem (20) veranlasste Strommessung anhand der Referenzstrommessung zu korrigieren; und
- einen Speicherschritt (E300) des Modells der elektrischen Maschine und des Konformationsmodells des Steuersystems in der Steuereinheit (50).

9. Kalibrierungsvorrichtung zur Schätzung eines von einer elektrischen Maschine (10), insbesondere von einem Motor mit Permanentmagneten, gelieferten Drehmoments, umfassend:
- eine Vorrichtung zum Messen eines elektrischen Stroms, die geeignet ist, den elektrischen Strom in der elektrischen Maschine (10) für einen Betriebspunkt der elektrischen Maschine (10) zu messen;
- ein Schätzmodell, das einem elektrischen Eingangsstrom ein Ausgangsdrehmoment zuordnet, so dass das Schätzmodell geeignet ist, ein von der elektrischen Maschine (10) für den Betriebspunkt der elektrischen Maschine (10) geliefertes Drehmoment aus dem gemessenen elektrischen Strom zu schätzen;
- einen Drehmomentmesser (40), der geeignet ist, ein von der elektrischen Maschine (10) für den Betriebspunkt der elektrischen Maschine (10) geliefertes Referenzdrehmoment zu messen; und
- eine Steuereinheit (50), die geeignet ist, das geschätzte Drehmoment mit dem Referenzdrehmoment zu vergleichen, wobei die Steuereinheit (50) ferner geeignet ist, das Schätzmodell in Abhängigkeit von dem Vergleich derart anzupassen, dass eine Differenz zwischen dem geschätzten Drehmoment und dem Referenzdrehmoment verringert, ja sogar aufgehoben wird.

10. Kalibrierungsvorrichtung nach Anspruch 9, die ferner umfasst:
- eine erste Kammer (110), die geeignet ist, erste Außenbedingungen zu reproduzieren, wobei die erste Kammer (110) geeignet ist, die elektrische Maschine (10) während der Kalibrierung aufzunehmen; und
- eine zweite Kammer (120), die geeignet ist, zweite Außenbedingungen zu reproduzieren, wobei die zweite Kammer (120) geeignet ist, das Steuersystem (20) der elektrischen Maschine (10) während der Kalibrierung aufzunehmen.

## Claims

1. A calibrating method for a model for estimating a torque provided by an electric machine (10), particularly by a permanent-magnet motor, comprising the following steps:
E1: measuring an electric current through the electric machine (10) for an operating point of the electric machine (10);
E2: estimating the torque provided by the electric machine (10) for said operating point of the electric machine (10), based on the electric current measured and on the estimation model associating an output torque with an input electric current;
E3: measuring a reference torque provided by the electric machine (10) for said operating point of the electric machine (10);
E4: comparing the estimated torque with the reference torque; and
E5: as a function of said comparison, adjusting the estimation model so as to reduce, or even cancel out, a difference between the estimated torque and the reference torque.

2. The calibrating method as claimed in claim 1, further comprising a step E6 of storing the adjusted estimation model in a memory of a control system (20).

3. The calibrating method as claimed in any of claims 1 and 2, wherein the steps E1 to E4 are repeated for several different operating points of the electric machine (10).

4. The calibrating method as claimed in any of claims 1 to 3, wherein the estimation model comprises an affine function, and wherein the adjustment of the estimation model comprises an adjustment of a gradient and/or of a y-intercept of the affine function.

5. The calibrating method as claimed in any of claims 1 to 3, wherein the estimation model comprises a lookup table associating with each of a plurality of electric input currents a corresponding output torque, and wherein the estimating of the torque in the step E2 comprises a recalibration of at least one output torque value of the lookup table during the step E5 as a function of the comparison between the estimated torque and the reference torque made in the step E4, such as to reduce or even cancel out the difference between the estimated torque and the reference torque.

6. The calibrating method as claimed in claim 5, wherein the estimation model comprises a set of lookup tables, each lookup table being associated with a temperature from among a set of operating temperatures of the electric machine (10), and wherein the estimating of the torque in the step E2 comprises a sub-step (E23) of selecting a lookup table associated with a temperature of the electric machine (10) at the operating point.

7. The calibrating method as claimed in any of claims 1 to 6, wherein the estimation model is adjusted so as to reduce, or even cancel out, a difference between the estimated torque and the reference torque, over a predetermined electric current range [Ik, In], and/or for a predetermined operating temperature range.

8. The calibrating method as claimed in any of claims 1 to 7, comprising:
- a step (E100) of calibrating the electric machine (10), comprising a sub-step (E101) of measuring the no-load electromotive force of the electric machine (10) and a sub-step (E102) of measuring a rotation speed of the electric machine (10), for an operating point of the electric machine (10), and a sub-step (E103) of determining an electric machine model associating with the electromotive force a rotation speed of the electric machine (10), based on the measured electromotive force and the measured rotation speed;
- a step (E200) of calibrating the control system (20), comprising a sub-step (E201) of measuring an electric current through the control system (20) on a static load test bench equipped with a master current sensor to obtain a reference current measurement, a sub-step (E202) of computing a measurement error on the quadratic current of the control system (20) with respect to the measurement of the reference current, and a sub-step (E203) of creating a shaping model in order to correct the current measurement commanded by the control system (20) based on the reference current measurement; and
- a step (E300) of storing the electric machine model and the shaping model of the control system in the control unit (50).

9. A calibrating device for estimating a torque provided by an electric machine (10), particularly by a permanent-magnet motor, comprising:
- a device for measuring an electric current suitable for measuring the electric current through the electric machine (10) for an operating point of the electric machine (10);
- an estimation model associating an output torque with an input electric current, such that the estimation model is suitable for estimating a torque provided by the electric machine (10) for said operating point of the electric machine (10), based on the measured electric current;
- a torquemeter (40) suitable for measuring a reference torque provided by the electric machine (10) for said operating point of the electric machine (10); and
- a control unit (50) suitable for comparing the estimated torque with the reference torque, the control unit (50) being moreover suitable for adjusting the estimation model as a function of said comparison, so as to reduce, or even cancel out, a difference between the estimated torque and the reference torque.

10. The calibrating device as claimed in claim 9, further comprising:
- a first chamber (110) suitable for replicating first external conditions, the first chamber (110) being suitable for receiving the electric machine (10) during the calibration; and
- a second chamber (120) suitable for replicating second external conditions, the second chamber (120) being suitable for receiving the control system (20) of the electric machine (10) during the calibration.
